# FASCICULE DE BREVET EUROPEEN

(11) **EP 0 730 327 B1**
(45) Date de publication et mention de la délivrance du brevet: **10.01.2001**
(21) Numéro de dépôt: 96400441.0
(22) Date de dépôt: 01.03.1996
(51) Int. Cl.: H01S 5/02, H01L 33/00

(54) **Ensemble modulaire incluant deux circuits électroniques à relier électriquement pour la transmission d'un signal hyperfréquence**
Modulare Anordnung mit zwei elektrisch zu verbindenden Schaltungen zur Übertragung eines Hochfrequenzsignals
Modular assembly including two electrically connectable electronic circuits for the transmission of a high frequency signal

(30) Priorité: 01.03.1995 FR 9502356
(43) Date de publication de la demande: 04.09.1996
(73) Titulaire: FRANCE TELECOM, 75015 Paris (FR)
(72) Inventeur: Kalonji, Ndiata, 92100 Boulogne Billancourt (FR); Semo, Jack, 91120 Palaiseau (FR); Tanniou, Jacques, 75011 Paris (FR)
(74) Mandataire: Texier, Christian

(56) Documents cités:
- WO-A-92/13369
- DE-A- 3 822 312
- US-A- 4 912 715
- IEEE TRANSACTIONS ON MICROWAVE THEORY AND TECHNIQUES, vol. 38, no. 5, 1 Mai 1990, pages 518-523, XP000133979 SCHLAFER J ET AL: "MICROWAVE PACKAGING OF OPTOELECTRONIC COMPONENTS"
- PATENT ABSTRACTS OF JAPAN vol. 017, no. 081 (E-1321), 18 Février 1993 & JP-A-04 279079 (MITSUBISHI ELECTRIC CORP), 5 Octobre 1992,
- PATENT ABSTRACTS OF JAPAN vol. 013, no. 051 (E-712), 6 Février 1989 & JP-A-63 244695 (FUJITSU LTD), 12 Octobre 1988,

## Description

La présente invention concerne le domaine de l'opto-électronique, et plus précisément un ensemble modulaire comprenant au moins deux modules à assembler et à relier électriquement pour la transmission d'un signal hyperfréquence d'un circuit électronique de l'un des modules vers un circuit électronique de l'autre module, l'un desdits circuits électroniques comportant au moins un composant opto-électronique relié optiquement à au moins une fibre optique.

Les composants opto-électroniques, propres à convertir un signal lumineux se propageant dans une fibre optique en un signal électrique ou réciproquement, ou à moduler un signal optique en fonction d'un signal électrique, sont habituellement reliés à des composants connexes purement électroniques. Ces derniers sont destinés au traitement (par exemple l'amplification, la mise en forme, ...) des signaux électriques provenant des composants opto-électroniques ou à acheminer vers ces derniers. Les composants électroniques connexes peuvent être montés, dans une première approche technologique, dite "monolithique" sur un même support que le ou les composants opto-électroniques auxquels ils sont reliés et, dans une deuxième approche technologique, dite "modulaire", sur un ou plusieurs supports distincts.

La première approche technologique précitée permet de bénéficier de la proximité des composants pour la transmission des signaux électriques entre le ou les composants opto-électroniques et les composants électroniques connexes. Elle présente toutefois l'inconvénient d'imposer le remplacement du support avec la totalité des composants montés dessus en cas de défaillance de l'un d'entre eux. En outre, les procédures de test destinées à vérifier le bon fonctionnement des composants électroniques connexes sont rendues plus difficiles par la présence des fibres optiques reliées aux composants opto-électroniques, qui impose de prendre des précautions particulières lors de la manipulation du support.

La deuxième approche technologique précitée vise à remédier à ces inconvénients et concerne une configuration dans laquelle les composants électroniques et opto-électroniques sont groupés, selon les fonctions qu'ils remplissent, sur des supports respectifs distincts. Les composants opto-électroniques sont regroupés sur un même support, auquel sont connectées les fibres optiques. La manipulation des circuits électroniques connexes, non reliés aux fibres optiques, est alors facilitée et en cas de panne, on peut remplacer le circuit défaillant seul. La connexion électrique des circuits électroniques soulève néanmoins des difficultés liées à la très haute fréquence (domaine de l'hyperfréquence) des signaux électriques à véhiculer entre les composants opto-électroniques et les composants connexes purement électroniques, qui sont éloignés des premiers.

On a proposé de relier les différents circuits électroniques, après les avoir placés dans des boîtiers respectifs, destinés à assurer leur protection mécanique et le blindage électromagnétique, par des rubans conducteurs. L'utilisation de ces derniers n'offre cependant pas entière satisfaction en ce qui concerne la bande passante obtenue.

On a proposé, dans la publication Journal of Lightwave Technology, Vol. 8, N° 9, September 1990 "A Novel Flip-Chip Interconnection Technique Using Solder Bumps for High-Speed Photoreceivers" d'améliorer la bande passante en disposant les circuits électroniques à relier face à face et en interposant entre eux des microsphères conductrices. Cette solution s'accompagne cependant de difficultés pratiques pour la mise en oeuvre du refroidissement des circuits, qui ne peut s'effectuer d'une manière habituelle à l'aide d'un plan de masse unique formé sur la face du support située du côté opposé à celle recevant les composants. En outre, la disposition en regard l'un de l'autre des circuits électroniques oblige à les monter dans un même boîtier et limite l'accessibilité aux circuits électroniques.

On a également proposé, dans l'article "Microwave Packaging of Otpoelectronic components", IEEE Transactions on Microwave Theory and Techniques, vol. 38, n°5, Mai 1990, p. 518-523, ainsi que dans le document DE 38 22 312 A1 et dans le document US 4 912 715, un boîtier pour un circuit optoélectronique relié à une ligne de transmission à hautes fréquences ainsi qu'à une fibre optique.

La présente invention concerne l'approche technologique dite "modulaire" et a pour but de remédier aux inconvénients précités.

Elle y parvient par le fait que, chaque module comprenant un boîtier dans lequel est placé un circuit électronique correspondant, les deux boîtiers présentant chacun une ouverture adaptée à recevoir une traversée hyperfréquence, chaque module comporte des moyens de butée axiale pour la traversée hyperfréquence et l'ouverture de chaque module est agencée de manière à ce que la traversée ainsi en butée axiale soit en contact éléctrique avec le circuit électronique de ce module.

D'autres caractéristiques et avantages de la présente invention apparaîtront à la lecture de la description détaillée qui suit, d'un exemple de réalisation non limitatif de l'invention, et à l'examen du dessin annexé sur lequel :
- la figure 1 est une vue schématique, en perspective éclatée, d'un module conforme à l'invention,
- la figure 2 représente isolément, en perspective, à échelle agrandie, une traversée hyperfréquence,
- la figure 3 est une vue schématique, en perspective, montrant la connexion électrique d'une traversée hyperfréquence et du circuit électronique d'un module,
- la figure 4 est une vue de dessus, schématique, montrant deux modules et un connecteur pour câble avant assemblage, et
- la figure 5 est une vue montrant les modules et le connecteur pour câble représentés sur la figure 4, après assemblage.

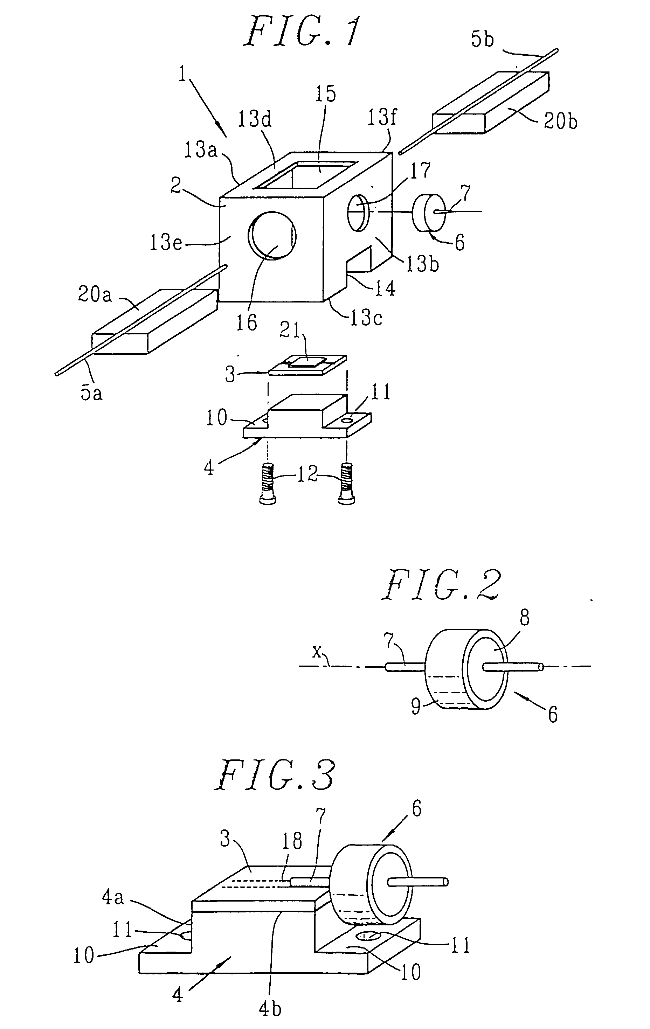

On a représenté sur la figure 1 un module 1 conforme à un exemple de réalisation de l'invention. Ce module 1 comprend un boîtier 2 creux, définissant un logement intérieur destiné à abriter un circuit électronique 3 monté sur une embase 4. Cette dernière est à rapporter sur le boîtier 2. Dans l'exemple décrit, le boîtier 2 est réalisé par usinage d'un cube en cuivre. On a référencé 13a et 13b deux faces latérales externes opposées du boîtier 2, 13c la face externe inférieure, 13d la face externe supérieure, 13e et 13f les deux autres faces latérales externes opposées.

Le circuit électronique 3 comporte, dans l'exemple décrit, un support ou substrat (en alumine de préférence) sur lequel sont réalisées des pistes conductrices de l'électricité et sur lequel est monté un composant opto-électronique 21 présentant deux faces optiques opposées, à relier à deux fibres optiques respectives 5a et 5b. Ces dernières sont portées, sur une portion de leur longueur adjacente à l'extrémité à relier optiquement au composant opto-électronique, par des supports respectifs 20a et 20b connus en eux-mêmes et représentés très schématiquement. Ces supports 20a et 20b sont à fixer sur les faces latérales 13e et 13f du boîtier 2 par soudage ou collage. Le composant opto-électronique 21 du circuit électronique 3, relié aux fibres 5a et 5b, est dans l'exemple décrit un modulateur connu en lui-même, apte à moduler en fonction d'un signal électrique reçu un signal optique incident acheminé par la fibre 5a pour délivrer vers la fibre 5b une onde lumineuse modulée. Le circuit électronique 3 est relié électriquement à un circuit électronique connexe non représenté sur la figure 1. La transmission des signaux électriques, dont la fréquence est du domaine de l'hyperfréquence (0 à 60 GHz), en direction du composant opto-électronique 21, s'effectue au moyen d'une traversée hyperfréquence 6, conformément à l'invention. Dans l'exemple décrit, le module 1 est apte à recevoir deux traversées hyperfréquences. Seule une traversée hyperfréquence, portant la référence 6 et apparaissant sur la figure 1, est utilisée.

Les traversées hyperfréquences sont connues en elles-mêmes car déjà utilisées dans une autre application sur des connecteurs pour câble de type SSMA. Dans l'exemple décrit, chaque traversée hyperfréquence provient du démontage d'un connecteur commercialisé par la société SCIEDIMES IBEXA sous la référence 1052335502. La traversée hyperfréquence, lorsqu'elle se trouve à l'origine intégrée dans le connecteur, est encore communément appelée "perle".

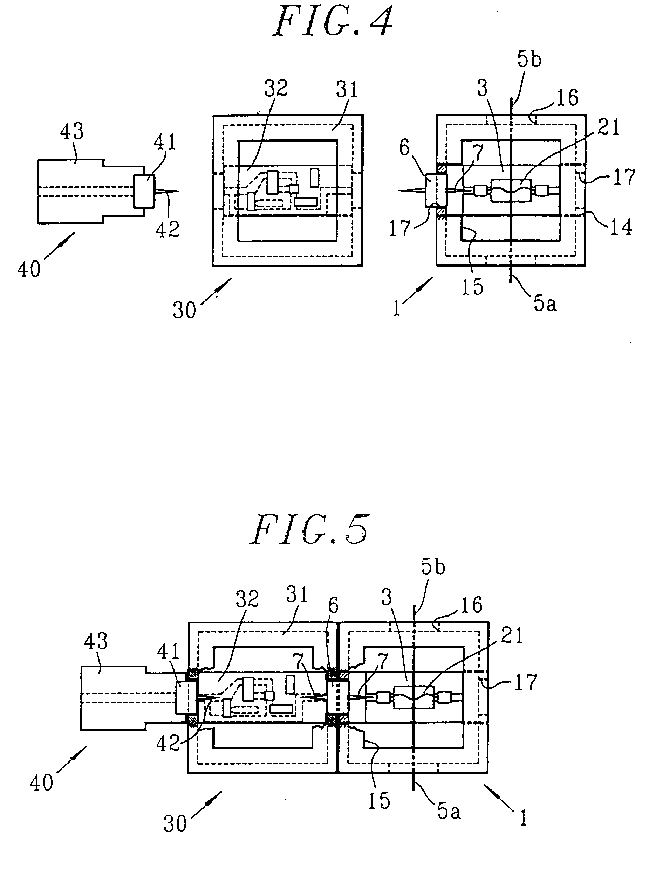

On a représenté isolément sur la figure 2 une traversée hyperfréquence 6 connue, telle que l'on peut la récupérer sur un connecteur précité. Cette traversée hyperfréquence 6 comporte une tige centrale 7, rectiligne, de section transversale circulaire, réalisée en un matériau conducteur de l'électricité, traversant un corps 8 en matériau isolant, lui-même entouré d'une bague métallique 9 à relier à la masse électrique. La tige conductrice 7, le corps isolant 8 et la bague conductrice 9 sont symétriques de révolution autour d'un même axe de symétrie X.

L'embase 4 représentée plus particulièrement sur la figure 3 présente une partie centrale 4a parallélipipédique, dont la face supérieure 4b reçoit le circuit électronique 3, et comporte de part et d'autre de cette partie centrale 4a deux pattes de fixation 10 traversées chacune par un perçage 11 pour le passage d'un élément de fixation 12 de l'embase 4 sur le boîtier 2. Dans l'exemple de réalisation décrit, ces éléments de fixation sont constitués par des boulons à visser dans des taraudages correspondants ménagés sur le boîtier 2. Le montage de l'embase 4 sur le boîtier 2 se fait par la face inférieure 13c, sur laquelle sont ménagées deux encoches 14 débouchant sur les faces latérales opposées 13a et 13b, pour accueillir les pattes de fixation 10 et assurer un positionnement précis de l'embase 4 dans le boîtier.

Le boîtier 2 est muni sur sa face supérieure 13d d'une fenêtre 15 permettant l'accès par le dessus au circuit électronique 3 lorsque ce dernier est en place à l'intérieur du boîtier 2. Deux ouvertures 16 sont ménagées sur les faces latérales opposées 13e et 13f du boîtier 2 pour le passage des fibres optiques 5a et 5b à relier au composant opto-électronique 21. Seule l'ouverture 16 débouchant sur la face latérale 13e est apparente sur la figure 1. Des ouvertures 17 sont ménagées sur les faces latérales opposées 13a et 13b du boîtier 2 pour le montage des traversées hyperfréquences. Seule l'ouverture 17 débouchant sur la face latérale 13b et recevant la traversée hyperfréquence 6 est apparente sur la figure 1. Les ouvertures 16 et 17 précitées sont des perçages circulaires traversant les faces latérales du boîtier 2, et sont réalisées en tenant compte de la position du circuit électronique 3 à l'intérieur du boîtier 2, de manière à ce que la tige conductrice 7 de la traversée hyperfréquence 6, après montage de cette dernière dans une ouverture 17, vienne au contact d'une piste conductrice 18 prédéterminée du circuit électronique 3, pour établir la connexion électrique souhaitée, et de manière à ce que les extrémités des fibres optiques 5a et 5b à connecter au composant opto-électronique 21 débouchent au voisinage immédiat de ce dernier et avec l'alignement requis. Le perçage 17 présente un diamètre adapté au diamètre externe de la bague 9.

La connexion électrique entre une piste conductrice 18 du circuit électronique 3 et la tige conductrice centrale 7 d'une traversée hyperfréquence se fait dans l'exemple décrit par simple contact mécanique, la tige 7 venant par une génératrice inférieure au contact de la surface externe supérieure de la piste. Au besoin, la tige centrale 7 est collée à la piste 18 au moyen d'une colle conductrice de l'électricité ou, en variante, soudée. La fenêtre d'accès 15 facilite alors le déroulement de ces opérations de collage ou de soudage.

On a représenté sur la figure 4 le module 1 précédemment décrit, à assembler avec un deuxième module 30 recevant lui-même un connecteur 40 de type SSMA, pour constituer un ensemble modulaire conforme à un exemple de réalisation de l'invention.

Le module 30 comporte un boîtier 31 logeant un circuit électronique 32 ne comprenant que des composants purement électroniques, ayant dans l'exemple décrit pour fonction d'amplifier et de mettre en forme les signaux électriques à envoyer au modulateur 21 du circuit électronique 3 du module 1. Le boîtier 31 est identique au boîtier 2 précédemment décrit, hormis l'absence d'ouvertures 16 pour le passage de fibres optiques.

Pour l'assemblage des modules 1 et 30, les boîtiers 2 et 31 sont disposés côte-à-côte, les deux faces latérales en vis-à-vis comportant chacune une ouverture pour le montage d'une traversée hyperfréquence. La traversée hyperfréquence 6 est alors disposée dans l'une de ces ouvertures, puis les boîtiers 2 et 31 sont rapprochés et assemblés par tout moyen connu de l'homme du métier (vissage, boulonnage, collage, soudage, ...). La traversée hyperfréquence relie alors électriquement les circuits électroniques 3 et 32, et s'étend pour moitié à l'intérieur de chaque boîtier 2, 31. La traversée hyperfréquence est avantageusement immobilisée axialement dans les perçages 17 des boîtiers par butée axiale de la bague 9 contre les parties centrales parallélipipédiques des embases 4.

Si nécessaire, le module 1 peut être relié électriquement à un deuxième module par une autre face latérale, dans l'exemple décrit celle située du côté opposé au module 30.

Le module 30 reçoit, dans l'exemple de réalisation décrit, un connecteur pour câble 40 de type SSMA, connu en lui-même, sur sa face latérale située du côté opposé au module 1. Ce connecteur 40 comporte un corps externe 43 pour la liaison mécanique avec un câble à une extrémité axiale et une "perle" 41 logée dans ce corps 43 pour la liaison électrique entre le câble et le circuit électronique 32. La "perle" 41 comporte une tige conductrice centrale 42 qui vient au contact d'une piste conductrice du circuit électronique 32.

Le corps du connecteur 40 peut être rapporté de façon amovible (par exemple par vissage) sur le boîtier 31, ou fixé à demeure sur ce dernier.

A titre indicatif, les principaux facteurs qui guident l'homme du métier dans le choix des matériaux pour réaliser le boîtier 2, l'embase 4, les supports 20a, 20b, le substrat du circuit électronique 3 sont les suivants :
- la technologie d'assemblage utilisée pour la fixation des supports 20a, 20b au boîtier 2 (soudage au laser YAG ou collage à l'aide d'une colle thermoconductrice ou électroconductrice, ...),
- la rigidité requise pour le boîtier 2 afin de lui permettre de supporter les contraintes mécaniques (pendant et après assemblage des modules) dans l'environnement où les modules seront utilisés,
- les conductibilités électrique et thermique (en vue de réaliser le blindage électromagnétique nécessaire, une dissipation de chaleur suffisante et la régulation de température requise pour le composant opto-électronique 21),
- la possibilité de métallisation par dépôt de nickel, de platine, d'or, d'indium ou d'un alliage or-étain de la face du substrat du circuit électronique 3 destinée à venir au contact avec la face 4b de l'embase 4,
- les coefficients de dilatation thermique en vue de minimiser les déformations des pièces pouvant conduire à un désalignement des portions des fibres optiques reliées au circuit électronique 3.

De façon préférentielle, on réalise le boîtier 2 en acier inoxydable ou en "dilver" (alliage connu composé principalement de fer, de nickel et de cobalt), ce qui permet de réaliser aisément la fixation des supports 20a et 20b sur le boîtier 2 par soudure au laser YAG. L'embase 4 est de préférence réalisée en "dilver". En variante, l'embase 4 est réalisée en un alliage de cuivre et de tungstène ou en cuivre.

Finalement, l'invention permet de relier plusieurs circuits électroniques sans dégradation importante de la bande passante. A titre indicatif, on a obtenu grâce à l'invention une liaison sans dégradation de la bande passante jusqu'à 27 GHz (± 0,5 dB). Chaque module permet en outre des accès optiques et électriques hyperfréquences multiples et aisés.

Bien entendu, l'invention n'est pas limitée à l'exemple de réalisation qui vient d'être décrit. On peut notamment ménager sur une même face latérale d'un boîtier plusieurs ouvertures pour accueillir des traversées hyperfréquences respectives, et disposer plusieurs circuits électroniques à l'intérieur d'un même boîtier.

## Revendications

1. Ensemble modulaire comprenant au moins deux modules (1 ; 30) à assembler et une traversée hyperfréquence (6), reliés électriquement lorsqu'assemblés pour la transmission d'un signal hyperfréquence d'un circuit électronique (3) de l'un (1) des modules vers un circuit électronique (32) de l'autre module (30), l'un (3) desdits circuits électroniques comportant au moins un composant optoélectronique (21) relié optiquement à au moins une fibre optique (5a ; 5b), chaque module (1 ; 30) comprenant en outre un boîtier (2; 31) dans lequel est placé un circuit électronique (3 ; 32) correspondant, les deux boîtiers présentant chacun une ouverture adaptée à recevoir une traversée hyperfréquence (6), caractérisé en ce que chaque module comporte des moyens (4) de butée axiale pour la traversée hyperfréquence (6) et en ce que l'ouverture de chaque module est agencée de manière à ce que la traversée ainsi en butée axiale soit en contact électrique avec le circuit électronique (3, 32) de ce module.

2. Ensemble modulaire selon la revendication 1, caractérisé en ce que chaque boîtier (2 ; 31) comporte sur deux faces opposées (13a ; 13b) deux ouvertures respectives (17) pour le montage dans ces dernières de traversées hyperfréquences (6).

3. Ensemble modulaire selon la revendication 2, caractérisé en ce que le boîtier (2) comportant le circuit électronique (3) incorporant au moins un composant opto-électronique (21) présente une forme générale parallélépipédique, avec, sur deux faces latérales opposées (13a, 13b) deux ouvertures (17) pour le montage de traversées hyperfréquences (6), et sur deux autres faces latérales opposées (13e, 13f), deux ouvertures (17) pour le passage de fibres optiques reliées au(x) composant(s) opto-électronique(s).

4. Ensemble modulaire selon l'une des revendications 1 à 3, caractérisé en ce que chaque boîtier (2 ; 31) présente sur une face supérieure (13d) une fenêtre d'accès (15) au circuit électronique (3) placé dedans.

5. Ensemble modulaire selon l'une des revendications 1 à 4, caractérisé en ce que au moins un des boîtiers (2 ; 31) présente une face inférieure (13c) ouverte pour le montage d'une embase (4) portant le circuit électronique à placer dans le boîtier.

6. Ensemble modulaire selon l'une des revendications 1 à 5, caractérisé en ce que l'un (31) au moins desdits boîtiers est adapté à recevoir un connecteur (40) pour câble.

7. Ensemble modulaire selon la revendication 6, caractérisé en ce que ledit connecteur (40) fait partie intégrante du boîtier (31).

8. Ensemble modulaire selon l'une des revendications précédentes, caractérisé en ce qu'un circuit électronique (3, 32) d'un des modules comporte une piste conductrice (18) et en ce qu'une ouverture de ce module est disposée par rapport au circuit éléctronique (3, 32), de façon à ce que lorsque la traversée (6) est disposée dans cette ouverture, la traversée (6) est au contact de la piste conductrice (18).

9. Ensemble selon l'une des revendications précédentes, caractérisé en ce qu'au moins un des modules comprend une embase (4) portant le circuit électronique (3, 32) de ce module, et en ce que les moyens de butée axiale pour la traversée hyperfréquence comprennent une partie de l'embase (4).

10. Ensemble modulaire selon l'une des précédentes revendications, caractérisé en ce que les ouvertures (17) ont des dimensions internes qui correspondent aux dimensions externes de la traversée hyperfréquence (6).

11. Boîtier (2 ; 31) pour ensemble modulaire tel que défini dans les revendications précédentes, comportant un logement intérieur pour recevoir un circuit électronique (3 ; 32), au moins une ouverture (17) ménagée dans une paroi du boîtier (2 ; 31) pour le montage d'une traversée hyperfréquence (6) en butée axiale, une fenêtre d'accès (15) au circuit électronique (3 ; 32), et une ouverture pour le montage d'une embase (4) sur laquelle est fixée ledit circuit électronique (3 ; 32), l'embase comportant des moyens de butée axiale pour la traversée hyperfréquence, et l'ouverture étant agencée de manière à ce que la traversée ainsi en butée axiale soit en contact électrique avec le circuit électronique de ce boîtier.

## Patentansprüche

1. Modulare Baueinheit mit wenigstens zwei zusammenzubauenden Modulen (1; 30) und einer Hyperfrequenz-Durchführung (6), die nach dem Zusammenbau für die Übertragung eines Hyperfrequenzsignals einer elektronischen Schaltung (3) von dem einen (1) der Module in Richtung einer elektronischen Schaltung (32) von dem anderen der Module (30) elektrisch verbunden sind, wobei eine (3) dieser elektronischen Schaltungen wenigstens ein opto-elektronisches Bauteil (21) aufweist, das optisch mit wenigstens einer Lichtfaser (5a; 5b) verbunden ist, jedes Modul (1; 30) außerdem ein Gehäuse (2; 31) aufweist, in dem eine entsprechende elektronische Schaltung (3; 32) angeordnet ist, die beiden Gehäuse jeweils eine Öffnung aufweisen, die zum Aufnehmen einer Hyperfrequenz-Durchführung (6) ausgelegt sind, dadurch gekennzeichnet, daß jedes Modul axiale Anschlagmittel (4) für die Hyperfrequenz-Durchführung (6) aufweist und daß die Öffnung jedes Moduls derart ausgestaltet ist, daß die sich im axialen Anschlag befindliche Durchführung in elektrischem Kontakt mit der elektronischen Schaltung (3; 32) dieses Moduls ist.

2. Modulare Baueinheit nach Anspruch 1, dadurch gekennzeichnet, daß jedes Gehäuse (2; 31) an zwei gegenüberliegenden Seiten (13a; 13b) zwei entsprechende Öffnungen (17) für den Einbau von Hyperfrequenz-Durchführungen (6) in die letzteren aufweist.

3. Modulare Baueinheit nach Anspruch 2, dadurch gekennzeichnet, daß das Gehäuse (2), welches die elektronische Schaltung (3) aufweist, die wenigstens ein opto-elektronisches Bauteil (21) eingebaut hat, eine im allgemeinen parallelepipedische Form aufweist, mit zwei Öffnungen (17) an zwei gegenüberliegenden Seitenflächen (13a, 13b) für den Einbau von Hyperfrequenz-Durchführungen (6) und zwei Öffnungen (17) an den beiden anderen gegenüberliegenden Seitenflächen (13e, 13f) für den Durchgang von mit dem(n) opto-eletronischen Bauteil(en) verbundenen Lichtfasern.

4. Modulare Baueinheit nach einem der Ansprüche 1 bis 3, dadurch gekennzeichnet, daß jedes Gehäuse (2; 31) an einer Oberseite (13d) ein Zugriffsfenster (15) zu der dort im Inneren angeordneten elektronischen Schaltung (3) aufweist.

5. Modulare Baueinheit nach einem der Ansprüche 1 bis 4, dadurch gekennzeichnet, daß wenigstens eines der Gehäuse (2; 31) eine Innenseite (13c) aufweist, die für den Einbau einer Basis (4) geöffnet ist, welche die in dem Gehäuse anzuordnende elektronische Schaltung trägt.

6. Modulare Baueinheit nach einem der Ansprüche 1 bis 5, dadurch gekennzeichnet, daß wenigstens eines (31) dieser Gehäuse ausgestaltet ist, einen Kabelverbinder (40) aufzunehmen.

7. Modulare Baueinheit nach Anspruch 6, dadurch gekennzeichnet, daß der Verbinder (40) einen integralen Teil des Gehäuses (31) darstellt.

8. Modulare Baueinheit nach einem der vorstehenden Ansprüche, dadurch gekennzeichnet, daß eine elektronische Schaltung (3; 32) eines der Module eine Leiterbahn (18) aufweist und daß eine Öffnung dieses Moduls bezüglich der elektronischen Schaltung (3; 32) derart angeordnet ist, daß beim Anordnen der Durchführung (6) in dieser Öffnung die Durchführung (6) in Kontakt mit der Leiterbahn (18) ist.

9. Baueinheit nach einem der vorstehenden Ansprüche, dadurch gekennzeichnet, daß wenigstens eines der Module eine Basis (4) aufweist, welche die elektronische Schaltung (3; 32) dieses Moduls trägt, und daß das axiale Anschlagsmittel für die Hyperfrequenz-Durchführung einen Abschnitt der Basis (4) umfaßt.

10. Modulare Baueinheit nach einem der vorstehenden Ansprüche, dadurch gekennzeichnet, daß die Öffnungen (17) Innenabmessungen haben, welche den Außenabmessungen der Hyperfrequenz-Durchführung (6) entsprechen.

11. Gehäuse (2; 31) für eine modulare Baueinheit, wie sie in den vorstehenden Ansprüchen definiert ist, das einen Innenraum zum Aufnehmen einer elektronischen Schaltung (3; 32), wenigstens eine in einer Außenwand des Gehäuses (2; 31) ausgesparte Öffnung (17) für den Einbau einer Hyperfrequenz-Durchführung (6) im axialen Anschlag, ein Zugriffsfenster (15) zu der elektronischen Schaltung (3; 32) und eine Öffnung für den Einbau einer Basis (4), auf der diese elektronische Schaltung (3; 32) befestigt ist, aufweist, wobei die Basis axiale Anschlagmittel für die Hyperfrequenz-Durchführung aufweist, und die Öffnung derart ausgestaltet ist, daß die sich im Anschlag befindliche Durchführung in elektrischen Kontakt mit der elektronischen Schaltung dieses Gehäuses ist.

## Claims

1. A modular assembly comprising at least two modules (1; 30) to be assembled together and a microwave feedthrough (6), the two modules and the feedthrough being electrically interconnected when assembled together for the purpose of conveying a microwave signal from an electronic circuit (3) in one of the modules (1) to an electronic circuit (32) in the other module (30), one of said electronic circuits (3) including at least one opto-electronic component (21) that is optically connected to at least one optical fiber (5a; 5b), each module (1; 30) further including a package (2; 31) in which the corresponding electronic circuit (3; 32) is placed, each of the two packages having an opening adapted to receive a microwave feedthrough (6), the modular assembly being characterized in that each module includes axial abutment means (4) for the microwave feedthrough (6), and in that the opening of each module is disposed in such a manner that the feedthrough thus in axial abutment is in electrical contact with the electronic circuit (3, 32) of the module.

2. A modular assembly according to claim 1, characterized in that each package (2; 31) has two openings (17) in two respective opposite faces (13a; 13b) for mounting microwave feedthroughs (6) in said opposite faces.

3. A modular assembly according to claim 2, characterized in that the package (2) containing the electronic circuit (3) that incorporates at least one opto-electronic component (21) is generally in the form of a rectangular block having two openings (17) in two opposite side faces (13a; 13b) to receive microwave feedthroughs (6), and two openings (16) through two other opposite side faces (13e, 13f) through which optical fibers connected to the opto-electronic component(s) can pass.

4. A modular assembly according to any one of claims 1 to 3, characterized in that each package (2; 31) has an access window (15) in a top face (13d) providing access to the electronic circuit (3) placed therein.

5. A modular assembly according to any one of claims 1 to 4, characterized in that at least one of the packages (2; 31) has an open bottom face (13c) for receiving a base (4) carrying the electronic circuit to be placed inside the package.

6. A modular assembly according to any one of claims 1 to 5, characterized in that one of said packages (31) is adapted to receive a cable connector (40).

7. A modular assembly according to claim 6, characterized in that said connector (40) is an integral portion of the package (31).

8. A modular assembly according to any preceding claim, characterized in that an electronic circuit (3, 32) of one of the modules includes a conductive track (18), and in that an opening of the module is arranged relative to the electronic circuit (3, 32) in such a manner that when the feedthrough (6) is arranged in said opening, the feedthrough (6) is in contact with the conductive track (18).

9. An assembly according to any preceding claim, characterized in that at least one of the modules comprises a base (4) carrying the electronic circuit (3, 32) of the module, and in that the axial abutment means for the microwave feedthrough comprise a portion of the base (4).

10. A modular assembly according to any preceding claim, characterized in that the openings (17) have inside dimensions that correspond to the outside dimensions of the microwave feedthrough (6).

11. A package (2; 31) for a modular assembly as defined in any preceding claim, the package having an internal housing for receiving an electronic circuit (3; 32), at least one opening (17) formed through a wall of the package (2; 31) for receiving a microwave feedthrough (6) in axial abutment, an access window (15) giving access to the electronic circuit (3; 32), and an opening for receiving a base (4) on which said electronic circuit (3; 32) is mounted, the base including axial abutment means for the microwave feedthrough, and the opening being disposed in such a manner that the feedthrough thus in axial abutment is in electrical contact with the electronic circuit of the package.
